# EUROPEAN PATENT SPECIFICATION

(11) **EP 2 648 213 B1**
(45) Date of publication and mention of the grant of the patent: **22.10.2014**
(21) Application number: 12163191.5
(22) Date of filing: 04.04.2012
(51) Int. Cl.: H01L 21/677

(54) **Apparatus and method for the transport on a liquid**
Vorrichtung und Verfahren für den Transport einer Flüssigkeit
Appareil et procédé pour le transport d'un liquide

(43) Date of publication of application: 09.10.2013
(73) Proprietor: RENA GmbH, 78148 Gütenbach (DE)
(72) Inventor: van Lent, Maarten, 5624 JX Eindhoven (NL); Olieslagers, Ruud, 5612 DN Eindhoven (NL); De Swart, Joseph A. M., 5144 WP Waalwijk (NL)
(74) Representative: Stürken, Joachim

(56) References cited:
- WO-A1-2009/153061

## Description

### Introduction

The present invention relates to apparatuses and methods for the transporting of substantially flat objects, wherein the transporting takes place by the use of a streaming liquid. More particularly, the invention relates to such apparatuses and methods wherein the velocity of the object can precisely be controlled.

### State of the art and disadvantages

In the context of the present invention, a "substantially flat object" is e.g. an object such as a silicon wafer used for semiconductor manufacture, or another flat substrate which e.g. may consist of glass, ceramics, or plastics. Such objects have, at least on one side, no significant protrusions which could interact with a transport means onto which they are placed.

A flat object is "freely movable" when it is not being carried, held, or guided by mechanically acting means. When the free movability is restricted in one or two dimensions, it still exists at least in a third dimension. Thus, even if the object is freely movable only along one dimension, this is still within the scope of the present invention.

Such flat objects usually need to be transported in the course of the manufacture of a product. Since the objects are often fragile, special care must be taken in order not to scratch or break them. However, common transportation devices usually involve mechanical means such as rollers, grippers, cassettes or the like. Consequently, mechanical damage of the objects cannot be avoided.

In order to overcome this problem, fluidically supporting transport means have been developed. Such a means is disclosed e.g. in document DE 40 39 313 Al. Herein, the transport takes place via a streaming liquid film which streams along the surface which is designed as a transport surface, thus carrying and pushing forward the substrates. For the generation of this liquid film the transport surface provides inclined gaps through which liquid flows bottom-up, and thus, against the substrate's underside. A motion direction is being given by the gap's inclination in transport direction. In order to ensure that the substrates to be transported remain on the transport device and do not laterally break out, the apparatus has lateral edges as guides along both sides of the transport surface.

In the context of the present invention, the liquid can be used for transport and/or treatment, e.g. for a mere support as well as (also) a cleaning, etching or coating of the object. However, in this particular case of a processing which goes beyond a mere transport, the substrates must very often be brought into contact with the treatment liquid during a defined period of time. During the transport, the treatment duration has an essential influence on the treatment result. But also in the case of the transport alone, it is essential that the velocity of each object in a row of subsequently transported objects is precisely controlled in order to avoid an object touching its preceding and/or subsequent neighbor due to velocity variations of the objects.

When following the teaching of the above mentioned document, it is only possible to a very limited extent to adjust and maintain the transport velocity which is done by means of changing the pressure of the emitting transport medium and/or the angle of inclination of the gaps. The initial transport velocity of the objects is being slowed down by unforeseeable incidental collisions with the guides, which results in an accordingly imprecise duration of the transport and, in the case of a simultaneous e.g. wet chemical treatment, in a non-uniform treatment result.

Other documents disclosing comparable transport methods which use a fluid (liquid or gas) as transporting medium are disclosed e.g. in US 3,761,002 or EP 0 408 021 B1, both disclosing an additional rotation of the object. While document US 3,761,002 discloses air cushions, lateral enclosures are necessary according to document EP 0 408 021 Bl in order to avoid a lateral drifting off of the objects to be transported. However, the imprecise control of the transport velocity remains.

A specific solution to the problem of (mechanically) contactless guiding of flat objects is disclosed in application PCT/EP2009/004461 of RENA GmbH (publication number: WO 2009/153061).

### Object of the invention

It is therefore object of the invention to provide an apparatus and a method which overcome the mentioned drawback of imprecise velocity control of a flat object which is transported by a liquid along a treatment surface.

### Description

According to the invention, the apparatus for the velocity controlled horizontal transport of a substantially flat and freely moveable object on a liquid comprises:
(i) at least one treatment surface with at least one inflow region having a multitude of pass-through openings out of which the flat object can be streamed against by a first liquid, in order to support the flat object approximately parallel to the treatment surface in a certain distance by means of a pressure rise beneath the object within the liquid layer, and
(ii) at least one discharge region for discharging (at least) said first liquid after provision of the inflow.

According to the invention, the apparatus is characterized in that the treatment surface is further equipped with (or, in other words, interrupted by) at least one pocket for the provision of a velocity controlling liquid roller, wherein said pocket has at its upstream edge an inlet through which a second liquid can be fed into said pocket in the form of a liquid jet stream (or "jet" in short). As a result, the liquid roller controls the speed of transportation of the object along the treatment surface by means of a horizontally orientated flow component of the jet. Optionally, the jet does also "support" the object by additionally providing a vertically orientated flow component. In fact, for temporarily stopping the object, the horizontally orientated flow component can become zero. However, this is less effective than the separation of bearing and feeding the object by means of a separation of inflow region and pocket.

Whereas the subsequent description refers to a jet which is "forward" directed (i.e., in transport direction), it is clear that the invention can be used with a reversely directed jet (contrary to the transport direction). In this case, it is clear that the respective means (in particular, the inlet) must be contrarily arranged. Such a reversely oriented jet can particularly be used for an exceptional quick deceleration of an object. A combination of "forward" and "reverse" pockets within the same treatment surface is possible as well.

As experiments have shown, the disclosed liquid roller is being superior to the nozzles known from the art with regard to the precise velocity control of the object. The horizontal component can easier be adjusted, and, because of its width, its velocity controlling effect on the object is more efficient.

Since, if desired, a simultaneous treatment shall take place in the context of the transport, the unifying term "treatment surface" is being used hereinbelow, wherein a "treatment" according to the invention does also comprise or exclusively relate to a "transport".

The treatment surface can be meant as a mere functional region, providing the functions of supporting and feeding forward. Preferably, it can denote a physical part of the apparatus, e.g. in the form of a rigid slab which carries the other parts such as, in particular, the pass-through openings and the pockets (see below). Moreover, the treatment surface can comprise and/or be accompanied by other transport means such as rollers, grippers, catches or the like which serve for additional support and/or velocity control of the objects.

According to the invention, the streaming liquid exits from at least one inflow region which is present on at least one treatment surface. The streaming liquid is directed in such a manner that it streams against the flat object, resulting in a pressure distribution that leads to the lifting of the object. It is possible that the liquid exits substantially perpendicular from the treatment surface and therefore perpendicularly impinges onto the flat object which is arranged parallel to the treatment surface, thus only lifting the object. Therefore, another appropriate term for the inflow region is "bearing region" since it serves for bearing the flat object. The thickness of the liquid film preferably ranges between 0.1 and 3 mm. Alternatively, it is possible that the liquid exits under an angle from the treatment surface, so that an additional motion component acts onto the object.

Subsequently, the liquid streams into at least one discharge region. This discharge region can for example be characterized by an overflow edge in the border region of the treatment surface, or also by according discharge openings (i.e. holes) within or beyond the treatment surface.

Preferably, the holding and track-adherent guiding of the object exclusively takes place by using a preferably streaming liquid, so that mechanically, i.e. non-fluidically, acting lateral edges, limiters, or other means for holding and guiding the object can be omitted. In this way, a mechanical damage of in particular the lateral edges of the flat objects can reliably be avoided. Further, the holding and guiding also takes place without mechanically acting limiters, guiding aids, holders or the same, such as for example holding devices, grippers, vacuum chucks, etc., which preferably would be arranged above and/or below the flat object. In this way, a mechanical damage of the usually very touch sensitive two-dimensional sides of the objects is largely prevented. This can be achieved in that the liquid discharges into the at least one discharge region laterally adjoining the treatment surface, so that a self-centering adhesion force develops between the flat object and the border between discharge region and treatment surface by which the object can be held and track-adherently guided on the liquid film without mechanical guiding aids.

In this preferred embodiment, when the freely movable substrate reaches, on its course along the treatment surface, the discharge region or crosses the border between the treatment surface and this discharge region, an equilibrium of forces develops between the flat object and the at least one discharge region. This equilibrium of forces which is particularly based on the formation of adhesion forces between the surface and the border of the discharge region results in that the flat object automatically, i.e. without interaction with mechanical devices, takes a preferred position which, according to the invention, corresponds to the desired, stationary position, or to the pre-determined position which follows the transport track, respectively. Furthermore, it also automatically returns to this preferred position when it is, for example by means of external application of forces, deviated from this position (self-centering effect). Such forces, in particular during transport, can act onto the object and result, without the automatic return motion, in leaving the pre-determined transport track.

According to a particularly preferred embodiment, the individual forces which cause the aforementioned equilibrium of forces symmetrically act on the flat object. This means that the inflow and/or the discharge region(s) is/are arranged symmetrically (i.e., at both sides) on or to the treatment surface, respectively, and therefore to the object to be held or to be guided.

According to the invention, the feed force which propels the object forward is exerted onto the flat object by a streaming liquid jet. Thus, this feed force is being provided independently from the force which is necessary for the holding or guiding. Preferably, the same type of liquid is being used for this as for the holding and guiding, and also, for an optimal treatment. The provision of the feed force by means of the directed jet of liquid represents a particularly effective means for avoiding mechanical damages of the usually fragile flat objects.

According to the invention, the aforementioned jet is provided by means of an inlet feeding the "feed liquid" (subsequently referred to as "second liquid") into a "pocket". This pocket is a recess or groove within the treatment surface, thus interrupting the otherwise substantially flat surface from which the object is spaced apart by means of the liquid flow of the aforementioned "first liquid" which streams out of the multitude of pass-through openings. It is clear that a sufficient number of pockets (i.e., more than one) must be present along the treatment surface in order to sufficiently homogenously exert the feed force onto the objects. Therefore, the pockets "interrupt" the treatment surface whose other areas are mainly covered by the inflow region(s) and, optionally, discharge region(s). It is clear that the actual preferred number and length of the pockets depends on e.g. the amount of force to be exerted, the amount of impulse to be transferred to the wafer, the wear-out of the jets etc.

The depth of the pocket is preferably such that the jet can develop freely. Therefore, no or very low shear stress develops at the bottom of the pocket, and the loss of momentum of the jet is minimized.

Because of the specific arrangement of the inlet, the aforementioned liquid roller develops, which acts as a correcting means for the speed of the object. If the object is too slow, the roller accelerates it, and if the object is too fast, it decelerates it. This correction is very effective, leading to a precise control of the speed of the object that traverses the pocket.

If a certain object velocity v is to be provided, the impulse amounts to ρ·A·v² (ρ=density of the liquid, A=opening area of the inlet). Thus, the (fixed) opening area of the outlet is determined. The required mass flow (ρ·A·v) is a direct outcome of these parameters. Thus, control of the mass flow implies control of the velocity and the related impulse.

According to a preferred embodiment, the at least one discharge region is laterally adjoining the treatment surface's at least one inflow region at least at one of its sides. In this case, the liquid level of the pocket is higher than the liquid level within the discharge region, such that the first and second liquid fall down over the lateral border(s) of the treatment surface.

In order to provide the aforementioned preferred symmetry of forces onto the flat object, it is preferred that two discharge regions are present at opposite sides (right and left) of the treatment surface since they facilitate to provide a lateral and rotational stabilization of the flat object on its course along the treatment surface. These discharge regions can, but must not, be of the type just described.

According to one embodiment, the second liquid is discharged from the pocket solely via the treatment surface, resulting in an "closed pocket" design providing no (or very restricted) regulated drainage. The term "closed" indicates that the pocket provides no other escape for the second liquid. So, the discharge region serves not only for discharge of the first liquid, but also of the second liquid. Therefore, no additional outlet must be provided in order to discharge the second liquid. Supply of first liquid must be regulated in order to provide a sufficient bearing liquid film, and supply of the second liquid must be regulated in order to maintain the required mass flow into the pocket as well as the motion impulse (jet velocity) for means of the independent feeding forward of the object. However, no regulation of the mass flow leaving the pocket is necessary (and possible). This keeps the construction most simple. The second liquid leaves the pocket via the treatment surface, partly as sideways spill-over, partly as a volume flow in transport direction. Since no additional outlet is present, a blockage of such an outlet by possibly present object fragments within the pocket cannot occur. However, drawbacks might exist if the first and the second liquid are not of the same type (i.e. should not be mixed), or if the outflow of the second liquid results in affection of the desired path of the object (e.g., the second liquid impairs proper functioning of the pass-through openings or the optionally present self-centering effect).

Furthermore, possible reactants are removed from the pocket via the surface flow, and some fraction of reactants may re-circulate within the pocket, both possibly being undesired. Also, the impulse of the jet quickly decreases after leaving the inlet because of its "branching" in all directions onto the treatment surface which takes place due to blockage of the jet at the opposite wall of the pocket.

A design which avoids the drawback of accumulation of reactants or debris provides an "open" pocket with no bottom at all, or with openings at the bottom that allow for complete pocket flushing, both having essentially the same effect that no debris can settle and obstruct the flow. In such a case, it is preferred that a reservoir is present that has the same liquid level as the pocket (i.e. at the treatment surface), because then, no additional adjusting of the liquid level of the pocket is necessary due to the "principle of communicating vessels". In such an embodiment, all fluid vessels are communicating with each other via the discharge region. For further information, reference is made to the according figure.

According to another embodiment, the pocket comprises at least one outlet. It is clear that this outlet is by definition different from the top opening.

In one embodiment, the outlet can be connected to the discharge region. The discharge region preferably has a liquid level lower than the pocket surface level. This design can be referred to as a "closed pocket", because it has no open bottom. The second liquid still can discharge into the discharge region, although not (mainly) via the treatment surface, but via an accordingly connected outlet. It is however clear that the outlet must have a certain hydraulic resistance, since otherwise, the pocket liquid level would become equal to the level in the discharge region. When the outlet is connected to a separate reservoir without any impairing (adjusting) means, the liquid level of the pocket can be adjusted by adjusting the liquid level of the reservoir (principle of communicating vessels, see above). Since the liquid level of the pocket needs to be at the level of the treatment surface, the second liquid will mainly discharge via the treatment surface, because no driving force (such as gravity) that would force the second liquid through the outlet exists. Thus, such an embodiment equates with the "open pocket" design. Furthermore, a problem of blocking the outlet exists.

In case such a driving force exists (gravity, pump connected to the outlet), the liquid will discharge through the outlet. As a result, the impulse of the jet onto the object is stronger and better defined when compared to the aforementioned embodiments lacking the outlet or the driving force, respectively, because the "branching" effect does occur less or not at all. Furthermore, reactants can also be removed through the outlet which is also an advantage.

It is clear that the surface level within the pocket must not be below the one of the inflow region because otherwise, fluid-wafer contact would be lost, and no propulsion would occur. At the same time, the level within the discharge region should be lower in order to develop the above described centring effect.

According to another embodiment, the outlet is connected to a "reservoir". This reservoir can, but must not be, the aforementioned discharge region. The first liquid does not, or at least not directly, enter into the reservoir, but into the (also present) discharge region, and on the other hand, the closed outlet-providing pocket does not communicate directly to the discharge region. The discharge region can be fluidically connected to the reservoir. Preferably, the discharge region can be provided as "drain channel" with a liquid level closer to the level of the treatment surface.

The advantage of these "closed" embodiments (no outlet or outlet with restricted drainage) is that the second liquid does not, or almost not, interfere with the flow of the first liquid. As a result, the amount of second liquid entering as well as leaving the pocket can be precisely controlled. This leads to an accordingly precise control of the fluid roller, and therefore, of the velocity of the object that traverses the pocket.

Regarding all embodiments comprising an outlet, the outlet is being preferably arranged opposite to and lower than the inlet. In this way, the liquid jet vertically widens from the upstream located edge of the pocket to the downstream located edge of the same. In other words, the jet evolves through the pocket, and grows in vertical direction due to liquid entrainment. Thus, the jet is directed mainly parallel to the free surface of the pocket, or slightly downwards into the pocket. The second liquid will therefore not, or almost not, flow onto the inflow region, but discharge into the outlet, as desired.

Preferably, the apparatus comprises a means for adjusting the mass flow and/or the impulse of the second liquid which is entering the pocket. Such a means can be e.g. provided by means of regulating a pump's pressure and/or the inlet's flow resistance. The mass flow mainly serves for adjusting the appropriate height level within the pocket, and the impulse is responsible for the desired velocity of the jet. However, both parameters can affect each other, so usually both must be properly adjusted. This adjustment can be achieved by either a regulated outlet (see below), or by providing no outlet, such that all liquid leaves the pocket via the treatment surface.

Optionally (if an outlet is also present), the apparatus preferably comprises means for adjusting the mass flow of the second liquid which is leaving the pocket via the outlet. This can be effected in particular by tuning the outlet's flow resistance, e.g. the flow resistance towards a drain reservoir which can be the discharge region.

If, as described, the mass flow (or volume flow, which is practically identical for incompressible media) at least at the inlet of the pocket is regulated, together with certain dimensions of the inlet opening, the inlet velocity, and hence the jet surface velocity and wafer velocity, can be determined. As a result, precise adjusting of the surface speed of the second liquid within the pocket takes place.

It is further preferred that a grating is arranged at the opening of the outlet. Such a grating serves as a means for holding back parts of broken objects which otherwise could possibly block the opening or the inside of outlet (discharge) duct. The grating can consist of a wire mesh, or e.g. of a multitude of small boreholes brought into a plate which is arranged at the entrance of the outlet. As a matter of course, other types of gratings can be used as well.

According to another preferred embodiment, a set of parallel wires running in transport direction is arranged at or slightly below the level of the treatment surface within the pocket for keeping broken objects from sinking into the pocket such that no physical contact with the bottom of the flat objects occurs. As a result, parts of broken objects will not sink into the depth of the pocket, but remain close to the surface, so that they can easily be discovered and removed by personnel. In fact, broken objects of sufficient size can discharge themselves by continuously following the desired track along the treatment surface.

According to another embodiment, several pockets are arranged perpendicular to the transport direction side by side. As a result, the width of the treatment surface, which also serves as a transport plane, is covered (or interrupted) not by one single, but by several pockets. This is particularly preferred in curves, because the innermost pocket will have to provide a lower surface velocity of the jet then the outermost pocket. According to this embodiment, different velocities along the width of the treatment surface are possible. Optionally, in particular in the case of curves, it is preferred that the pockets have different lengths in transport direction.

It is further preferred that the length in transport direction is such that a whole and identical number of pockets and inflow regions fits beneath an object. One preferred number is four. If e.g. the object is a typical 6 inch silicon wafer, it is preferred that four pockets and four inflow regions, each having length of 19.05 mm (or approx. 20 mm), fit under this wafer.

In other words, along the length of one object, a similar number of pockets and inflow regions are subsequently and alternately arranged one after another in transport direction. When a pocket followed by an inflow region is called a "set", preferably, a whole number of sets fits under a flat object.

Furthermore, the cumulated length of pockets along a section of the treatment surface is approximately equal to the cumulated length of the inflow regions of this section. This section preferably corresponds to the length of one flat object. In other words, the ratio of cumulated pocket length to cumulated inflow region length is preferably within the range of 0.5:1 1 to 5:1, more preferably equal or greater than 1, and particularly preferred, both lengths are equal to each other. In this way, the flat object is still properly held in the desired distance from the treatment surface, while its velocity is continuously and precisely controlled due to the large surface area of the object which is simultaneously located above one, or preferably several, pockets.

As mentioned above, pockets can have the width of the treatment surface, but other pocket distributions are possible as well.

It is particularly preferred that in the case of presence of an outlet, the opening area of the inlet is smaller than the opening area of the outlet. Since the vertical dimension of the liquid jet increases in transport direction by fluid dynamic interaction, it is preferred that the outlet is larger than the inlet.

In case that the pocket has enough depth, a region of little or no flow can develop below the liquid jet. Preferably, the pocket depth amounts to 0.5 to 1 times the pocket length which is measured in transport direction.

In this region, debris or small parts of broken objects can remain in the pocket without interfering with the jet, otherwise resulting in loss of jet momentum, or in obstructing the preferably present outlet.

It is clear that the fluidic behaviour of the liquid jet is strongly influenced by the geometric measures of the pocket.

Therefore, the opening of the inlet has an (average vertical) height which ranges from 1 to 5, and preferably amounts to 3 mm, and the (average vertical) position of this opening (measured from the level of the treatment surface) ranges from 1 to 5, and preferably amounts to 2 mm.

The opening of the optional outlet has an (average vertical) height which ranges from 2 to 10, and preferably amounts to 5 mm, and the (average vertical) position of this opening (measured from the level of the treatment surface) ranges from 2 to 10, and preferably amounts to 4 mm. In another preferred embodiment, the outlet height amounts to, or slightly underruns, the pocket depth, i.e. has the maximum height possible. Thus, the average vertical position amounts to half of the pocket depth.

In general, the jet should be as close to the surface as mechanically possible.

According to a further embodiment, the inflow regions are arranged on the treatment surface in a V-shape. This means that in a top view, when the treatment surface is divided by a center line into two halves (a right and a left one), the strip-shaped inflow regions of both halves are rotated such that the short axis of each strip forms an angle with respect to the transport direction.

As a result, better process homogeneity and less resistance variations at the inflow regions are achieved because of an optimization for minimal disturbance during wafer transport.

According to another embodiment providing a multitude of pockets, the respective inlets and/or (optionally present) outlets of these pockets are fluidically combined with each other. As a result, only one means for adjusting the mass flow and/or hydraulic resistance must be provided, as long as, e.g. because of identical geometries, all connected pockets provide jets of the same velocity. Then, velocity control can be effected by adjusting only a single means for adjusting.

Although the invention has been described by way of a single sided transport (and optional treatment), according to another embodiment, the double-sided transport (and optional treatment) / velocity control is possible as well by the invention. In this case, the aforementioned liquid roller(s) contact(s) the flat object at its under- and top side, being provided by accordingly arranged pockets. This embodiment allows as well using pockets of all the aforementioned types.

Regarding such an arrangement, depending on the task at hand, it may be advisable to provide a bilaterally symmetric arrangement of the pockets (i.e., an identical number of pockets above and below the object, or pockets of identical effects on both sides), or it may be advisable to provide an asymmetric arrangement, e.g. more pockets below then above the object. At the same time, the number of inflow regions (or their effects onto the object) can be identical on both sides of the object, or they can differ. E.g., the number of inflow regions below the object can be higher than above the same, or vice-versa. It is also possible that inflow regions are present on one, and pockets are present on the other side of the object, wherein the pockets are preferably, but not mandatorily, arranged below the object.

The discharge region in this case can still be located besides the treatment surfaces, but it is also possible to provide a "closed" system where the liquids stay in sort of a "transport and treatment channel". However, such an embodiment does not allow for the preferred adhesion based self-centring effect described above.

In the following, the method for the velocity controlled horizontal transport of a substantially flat and freely moveable object on a liquid according to the invention is described.

The flat object is streamed against by a first liquid which is emitted from a multitude of pass-through openings which are comprised by at least one inflow region of at least one treatment surface, and (at least) said first liquid is discharged after provision of the inflow into at least one discharge region laterally adjoining the treatment surface's at least one inflow region at least at one of its sides.

According to the invention, a velocity controlling fluid roller with a flow component in transport direction is provided in the form of a jet stream of second liquid which is fed through an inlet being arranged at a pocket's upstream edge into said pocket, the pocket being also present in the treatment surface.

As a result, the fluid roller controls (in terms of acceleration and deceleration) the speed of transportation of the object along the treatment surface since the object, upon traversing the pocket, adapts to the surface speed of said flow component by means of drag flow. Optionally, but not preferred, the jet can be used for complementary supporting the object as well.

For a detailed explanation of the aforementioned components, in order to avoid repetitions, reference is made to the above description concerning the apparatus according to the invention.

In other words, a method according to the invention comprises the following steps:
- providing a vertically acting (first liquid) support pressure from below an object, resulting from the inflow region's outflow and the effective flow resistance as well as the pressure field beneath the flat object, in order to keep it at a certain distance parallel to a treatment surface, carrying the object;
- providing a (mainly) horizontally oriented liquid jet (second liquid) acting as drag flow at the free surface of a pocket which is comprised by the treatment surface, imposing its velocity to the object which therefore adapts to the jet velocity at the surface of the pocket;
- discharging at least the first, and optionally the second, liquid into a discharge region.

As a consequence, the support and the feed function are separated from each other. The second liquid's flow suits to precisely control the velocity of the object when the same traverses the pocket(s). This is achieved by (i) precisely adjusting the mass flow into (and optionally out of) the pocket, and (ii) by providing a sufficiently large area of the surface of the pocket(s) contacting the underside of the object.

According to the invention, the second liquid is discharged via the treatment surface and/or via an open bottom which is arranged within the pocket. Preferably, the second liquid is discharged into the discharge region.

When the second liquid is discharged via the treatment surface, there is no problem of the pocket falling dry, since there is no other way of this liquid leaving the pocket. This leads to an easy construction, but limits the possibilities of mass flow adjustment, and it is also less effective due to the branching effect (see above).

When the second liquid is discharged by means of an outlet being preferably connected to the discharge region, the second liquid leaving the pockets does not interfere with the first liquid which is emitted on to the treatment surface by means of the inflow regions for support of the object. In this case, the liquid level of the discharge region is preferably below the liquid level on the treatment surface in order to maintain the aforementioned self-centring effect.

According to another embodiment, the second liquid is discharged into at least one outlet which is arranged within the pocket and which ends in a reservoir. This reservoir can be different from the aforementioned discharge region (see above), and the mass flow of the second liquid leaving the pocket is adjusted by according means. As a result, more possibilities of mass (or volume) flow adjustment exist.

It is clear that the inflowing mass flow of the second liquid entering the pocket shall be equal to or greater than the outflowing mass flow leaving the pocket. In this way, it is ensured that the liquid jet is provided at a sufficient height in order to properly contact the underside of the object. It is clear that this prerequisite should be met no matter where the liquid is discharged into.

According to a particularly preferred embodiment, adjustment of the surface speed takes place by adjusting the second liquids mass flow (or volume flow) entering the pocket, and/or by adjusting the impulse of the second liquid entering the pocket, e.g. by means of regulating a pump's pressure, or by influencing the inlet's flow resistance. The height level within the pocket, and optionally, the speed, is adjusted by adjusting the mass flow (or volume flow) leaving the pocket via the outlet, e.g. by tuning the hydraulic resistance of the outlet, by using a pump or simply using gravity.

So, the object's velocity control takes place by adjusting the mass flow, thus influencing the speed of the jet, and therefore, the object velocity which adapts to the jet speed at the liquid surface at the pocket surface.

According to another preferred embodiment, the surface speeds of the jets of a multitude of pockets are commonly adjusted by adjusting their common in- and/or out flowing mass flow and/or the hydraulic resistance of the respective ducts.

It is preferred that the means for common control of the inflow of the second liquid into the pockets is a common pump. By adjusting e.g. the pump's rotational speed, its delivery rate can be adjusted in a simple manner.

The means for the common control of the outflow of the second liquid leaving the pockets can preferably be a simple valve having e.g. a variable opening width. The larger the opening of the valve is, the more of the second liquid will leave the pockets, since the hydraulic resistance changes.

The velocity of the object is approximately proportional to the speed of the liquid jet and therefore to the inflowing mass flow. The outflowing mass flow Mₒᵤₜ typically depends on the height of the liquid level within the pocket in respect of the height of the liquid level within the reservoir into which the second liquid is discharged (or more precisely, the gravity field potential energy), as well as the hydraulic resistance Rₒᵤₜ of the outlet and the subsequent ducts, and the hydraulic resistance of the aforementioned means for adjusting which is arranged downstream of the outlet.

By adjusting said means, the mass flow of the second liquid which does not leave the pocket via the outlet but over the treatment surface can be adjusted. Preferably, this latter means is adjusted such that said mass flow remains constant for all desired object velocities; velocities must then be influenced by e.g. the inlet opening area. As a result, the height of the liquid film consisting mainly of first, but partially also of second liquid can be kept constant, which is an important goal with regard to a safe transport of the object.

In the preferred case of identical pockets, equal hydraulic resistances should be present in order to allow for an equal division of mass flow rates.

In general, the mass flow rates of several pockets should be equalized by tuning the individual hydraulic resistances.

It is also particularly preferred that the motion impulse of the second liquid entering the pocket is adjusted to be large with respect to the motion impulse transferred to the object (acceleration + drag). As a rule of thumb, the first should be at least twice and not more than five times as much as the latter, wherein lower mass flow rates are preferred.

Generally speaking, the jet shall have sufficient momentum to accelerate the object to a certain desired speed and to compensate several drag contributions, without being worn out (no or insufficient impulse left). In other words, the jet shall provide a propulsion force to the object sufficient to accelerate the wafer (range of e.g. 0.1 to 1 m/min), counteract the drag experienced at the inflow region(s), counteract the additional drag in case of a double sided transport / treatment, and counteract the drag from possibly present separation or drying stations along the transport track. E.g., in the case of silicon wafers as flat objects, a total force of 0.15 to 1.0 mN acting on the object by all pockets simultaneously interacting with the object is found to be sufficient to achieve this goal.

According to another embodiment, a region of little or no flow develops below the liquid jet. Thus, small debris can settle in this region, not influencing the liquid jet. Preferably, the vertical dimension of the liquid jet increases in transport direction until the end of the pocket. The settling region then preferably develops below that region of the jet where it is farthest away from the bottom of the jet. It is clear that the depth of the pocket must be large enough so that the jet does not interact with all the bottom area of the pocket.

The present invention effectively solves the problem of imprecise velocity control of a flat object which is transported by a liquid along a treatment surface by providing an apparatus and a method which overcome the drawbacks of the art regarding imprecise velocity control. By regulating the mass flow (or volume flow, which is equivalent in case of incompressible liquids), e.g. by adjusting hydraulic resistance, and/or the motion impulse at least at the entrance of the pocket, together with certain dimensions of the inlet opening, the inlet velocity, and hence the jet surface velocity and wafer velocity, can be determined. As a result, precise adjusting of the surface speed of the second liquid within the pocket takes place.

### Description of figures

- **Figure 1**: shows a liquid based transport device according to the state of the art in a top view.
- **Figure 2**: shows such a transport device in a cut view.
- **Figure 3**: shows an apparatus according to the invention.
- **Figure 4**: shows an apparatus according to the invention having outlets.
- **Figure 5**: shows a cross section of an "open pocket design" with discharge region and reservoir.
- **Figure 6**: shows a pocket according to the invention having no outlet in a side view.
- **Figure 7**: shows a pocket according to the invention with an outlet in a side view.
- **Figure 8**: shows an apparatus with a multitude of pockets with outlets and a reservoir in a side view.
- **Figure 9**: shows a top view onto a treatment surface with V-shaped arranged inflow regions.

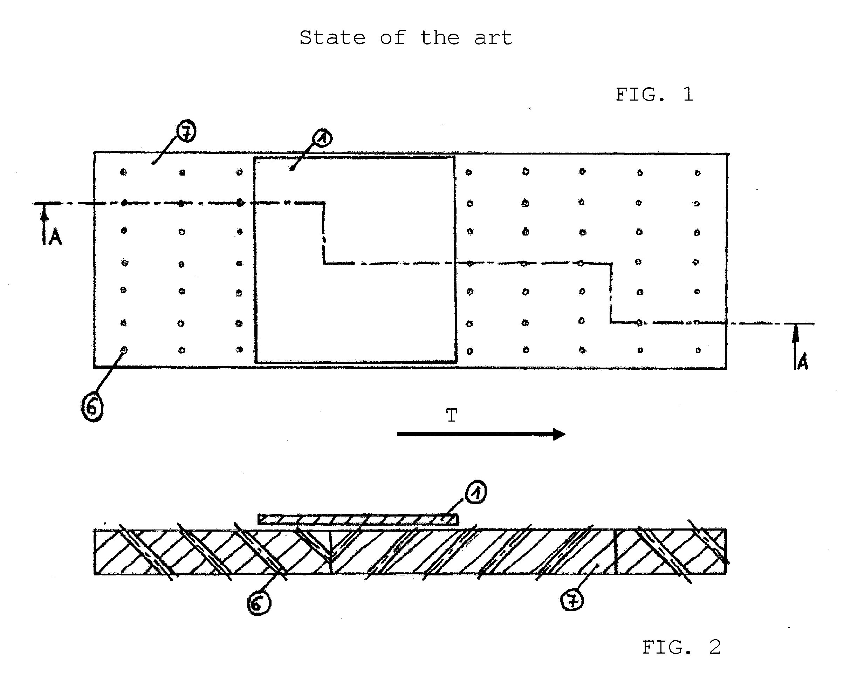

The **figure 1** shows a top view onto a liquid based transport device according to the art with a flat object 1 being placed onto. Several rows of pass-through openings 6, forming a large inflow region (numeral omitted), are present on the treatment surface 7 which are connected with a not shown feed and discharge system being arranged below the treatment surface 7. A cut line whose associated side view is shown in **figure 2** is also depicted. Well visible are the angled pass-through openings 6 which are inclined partially in the transport direction T, pointing to the right, and partially contrary to the same. It is visible as well that also on the very same row of pass-through openings 6, i.e. in a respectively identical distance to the side of the treatment surface 7, different inclinations are provided. Accordingly, these pass-through openings 6 can optionally be used for accelerating or decelerating the substrate, provided that they are controllable in groups.

Although a certain control of the velocity of the object is possible by means of such a device, control is not precise enough for certain purposes. As a result, subsequent objects must have significant distances between each other in order to avoid collisions, treatment times differ, and the fluidic connection of the aforementioned groups requires according efforts. The addition of (not depicted) mechanical catches for controlling the velocity is disadvantageous due to the extra effort as well as the mechanical contact between catch and flat object.

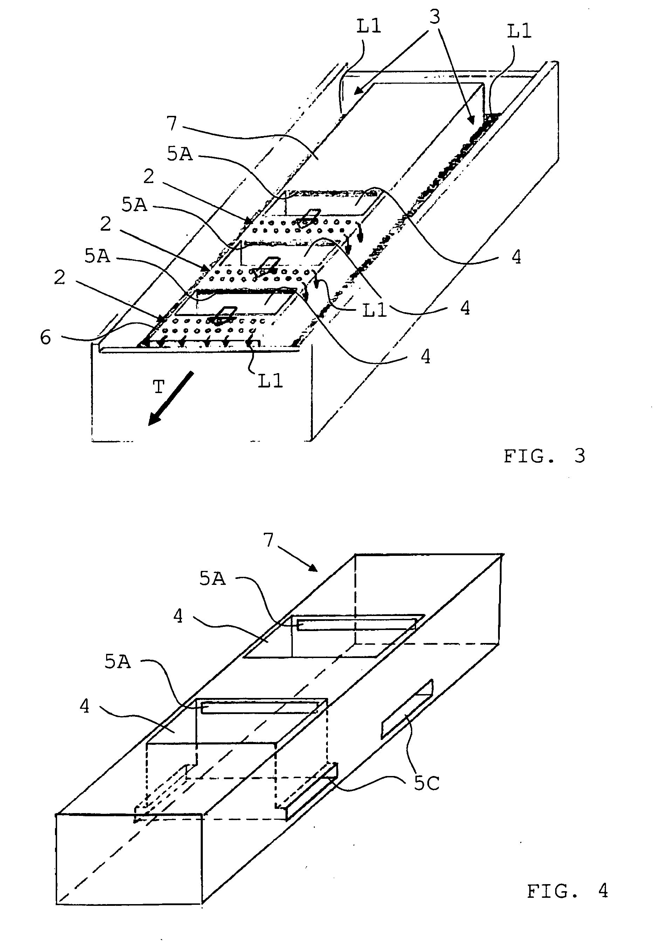

In **figure 3**, an apparatus according to the invention is depicted. The treatment surface 7 comprises inflow regions 2, each comprising a multitude of pass-through openings 6.

The treatment surface 7 is interrupted by a multitude of pockets 4. In this embodiment, the pockets 4 have approximately the same length in transport direction T as the inflow regions 2. The inlets 5A are visible as dark bars. However, the second liquid exiting these inlets 5A is not explicitly shown.

Adjoining both sides of the treatment surface 7, a discharge region 3 is located, wherein at least the first liquid L1 is discharged into. The first liquid L1 is that liquid which is emitted from the inflow regions 2. In this embodiment, the discharge regions 3 do not only laterally adjoin the inflow regions 2, but also the pockets 4, which must not be the case in other, not depicted embodiments.

Thus, the embodiment of figure 3 depicts the situation of a closed pocket with surface drainage, or the situation of a closed pocket with regulated drainage through according outlets (not visible) which discharge the second liquid exiting the pocket not via the surface, but into the discharge region or a (not shown) reservoir.

In **figure 4**, an apparatus according to the invention is depicted showing inlets 5A and an open bottom 5C (open pocket design). Each inlet 5A is arranged close to the upper edge of the according pocket 4. Second liquid (not shown) can be emitted into the pocket 4, and discharged from the pocket 4 via the open bottoms 5C. The depicted open bottoms 5C must not be mistaken for (not shown) outlets, since they neither provide a fluidic restriction, nor are they arranged opposite to the inlets 5A, but perpendicular to the jet (not shown).

In the depicted embodiment, all open bottoms 5C discharge into a common reservoir (not shown). Thus, all pockets are fluidically connected. However, the depicted embodiment can also be used for (additional) surface drainage of the second liquid (not shown).

As can be derived from the drawing, the lateral width of a pocket is almost equal to the width of the treatment surface 7. However, several pockets can be placed side by side instead (not shown).

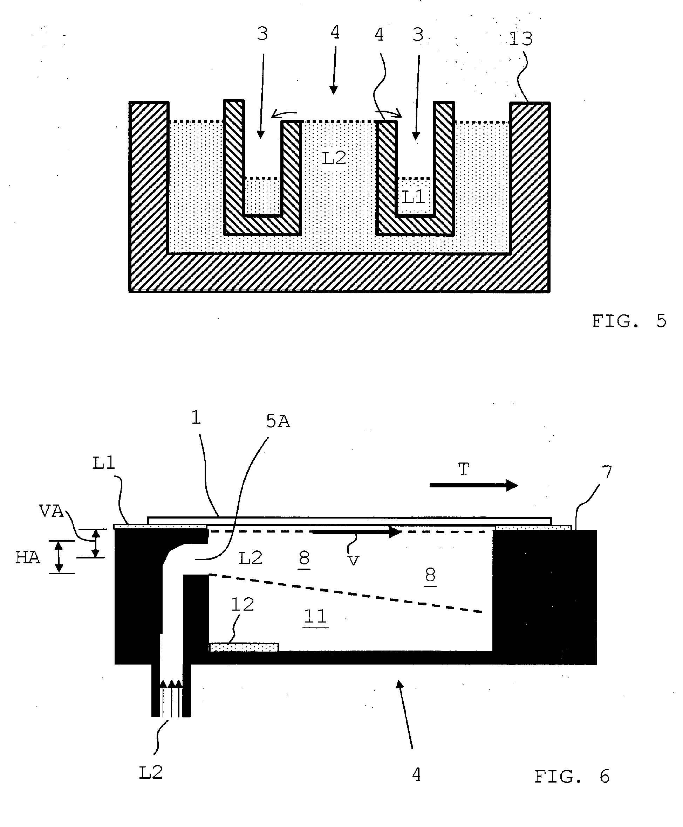

In **figure 5**, a cross section of an "open pocket design" with discharge region 3 and reservoir 13 is depicted. The pocket 4 is filled with second liquid L2 (injecting inlets not shown). Besides the pocket 4, discharge regions 3 are located. First liquid L1 flows into them from both sides of the treatment surface 7 (small arrows without number, inflow region not shown). Besides the discharge regions 3, a reservoir 13 is present. It contains the second liquid L2 and provides a certain liquid level. As can be seen, due to the principle of communicating vessels, the liquid level of the pocket has the same height.

Not depicted is a pump which delivers the first liquid L1 into the reservoir 13 (in case that the two liquids L1, L2 can be mixed up or are identical), or pumps for feeding the first and second liquid L1, L2 onto the inflow region or pocket 4, respectively.

If desired, the arrangement can be combined with the arrangement shown in the next figure.

In **figure 6**, an apparatus according to the invention with a pocket 4 having no outlet is shown (closed bottom). The flat object 1 is arranged parallel to the treatment surface 7, floating on first liquid L1. At the same time, second liquid L2 streams into the pocket 4 through an inlet 5A. A liquid jet stream 8 develops, its widening borders are indicated by the dashed lines. With increasing distance from the inlet 5A, the vertical dimension of the jet 8 increases as well.

As can be easily derived, the jet 8 has a main flow component in transport direction T, being congruent with the velocity v. This flow component results in the feed of the object 1, wherein the velocity of the object adapts to the surface velocity v of the jet 8.

Below the jet 8, a settling region 11 develops where little or no flow occurs. Debris 12 settles down which does not impact the functioning of the apparatus.

It is clear that the second liquid L2 can in this case only be discharged via the treatment surface 7.

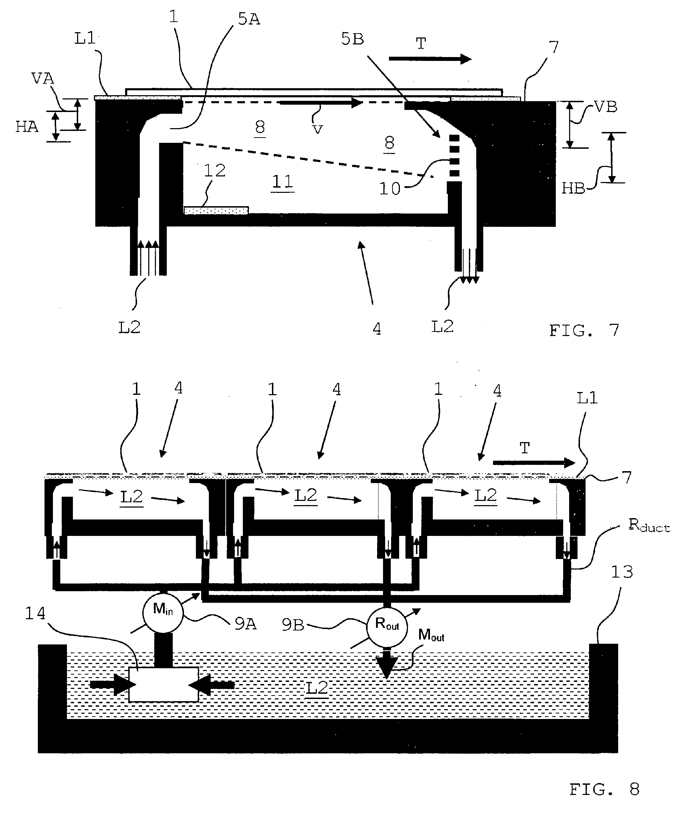

In **figure 7**, the apparatus according to the invention has a pocket 4 having an outlet 5B. Second liquid L2 enters the pocket 4 via the inlet 5A, and leaves it via the outlet 5B.

A grating 10 is arranged at the opening of the outlet 5B. Such a grating 10 serves as a means for holding back parts of broken objects (not shown) which otherwise could possibly block the outlet opening or enter the outlet duct and block it internally.

As can be seen, the (average) vertical position (VA) of the inlet (5A) is higher than the (average) vertical position (VB) of the outlet (5B). This results from the fact that they both begin closely below the treatment surface, but, because of the increase of the jet dimension, the opening height of the outlet HB is greater than the opening height of the inlet HA. Thus, the jet's imaginary center line (not shown) is slightly directed downwards, i.e. away from the top surface. Therefore, second liquid L2 will mainly not be discharged via the treatment surface 7, but through the outlet 5B, as desired.

In **figure 8**, an apparatus with a multitude of pockets 4 with outlets and a reservoir 13 in a side view is shown. The pockets 4 are arranged subsequent to one another in transport direction T. Above each pocket 4, a flat object 1 is floating on a thin film of first liquid L1 (inflow regions between pockets not shown). Within each pocket 4, second liquid L2 is present. It is conveyed by a common pump 14 (inflowing mass flow Mᵢₙ, adjustable) out of a common reservoir 13 and via distribution ducts to the inlets of the respective pockets 4. Corresponding discharge ducts serve for piping the second liquid L2 from the pockets 4 back into the reservoir 13. The flow paths of the second liquid L2 are symbolized by black arrows (not to scale).

As can be seen from the figure, all pockets 4 are fluidically combined with each other. However, a means 9A for adjusting the mass flow Mᵢₙ of the second liquid L2 which is entering the pockets 4 is provided. By this means 9A, the amount of liquid L2 entering the pockets 4 can be adjusted. As a result, the velocity of the jets and hence, of the flat objects 1, is influenced by this single means 9A.

Within the discharge ducts which serve for piping the second liquid L2 back into the reservoir 13, a means 9B for adjusting the hydraulic resistance Rₒᵤₜ of these discharge ducts is provided in the according flow path. So, the amount of second liquid L2 which is drawn from the pockets 4 (outflowing mass flow Mₒᵤₜ) via these discharge ducts, and as a result, the remaining amount which must leave the pockets 4 via the treatment surface 7, is adjusted. Consequently, the height of the objects 1 above the treatment surface 7 (liquid film thickness) is adjusted as well. It is clear that in this system, Mₒᵤₜ depends on the potential energy (ρ*g*h, wherein ρ is the density, g is the gravity constant, and h is the height difference between liquid surface of the pockets 4 and reservoir 13), R_{duct} (hydraulic resistance of the ducts, only one with reference numeral) and Rₒᵤₜ (hydraulic resistance of the common discharge ducts; adjustable). Equal hydraulic resistances in all ducts are preferred in order to achieve an equal division of mass flow rates and thus, a provision of equal jets within all pockets 4.

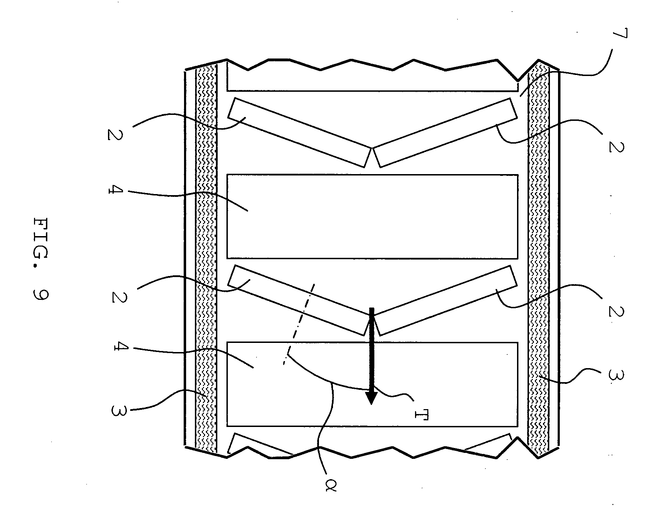

**Figure 9** shows a top view onto a treatment surface 7 with V-shape arranged inflow regions 2. The pockets 4 are arranged perpendicular to the transport direction T, whereas the strip-shaped inflow regions 2 (pass-through openings omitted) of both halves of the treatment surface 7 are rotated such that the short axis (indicated by the dash-dotted line) of each strip forms an angle α with respect to the transport direction T.

### List of reference numerals

- 1: flat object
- 2: inflow region
- 3: discharge region
- 4: pocket
- 5A: inlet
- 5B: outlet
- 5C: open bottom
- 6: pass-through opening
- 7: treatment surface
- 8: liquid jet stream, jet
- 9A, 9B: means for adjusting the mass flow
- 10: grating
- 11: settling region
- 12: debris
- 13: reservoir
- 14: pump
- T: transport direction
- α: angle
- v: surface velocity, velocity of the jet
- HA: opening height of the inlet, height level
- VA: vertical position of the inlet
- HB: opening height of the outlet, height level
- VB: vertical position of the outlet
- Mᵢₙ: inflowing mass flow
- Mₒᵤₜ: outflowing mass flow
- Rₒᵤₜ: hydraulic resistance of common discharge ducts
- R_{ducts}: hydraulic resistance of discharge ducts

## Claims

1. Apparatus for the velocity controlled horizontal transport of a substantially flat and freely moveable object (1) on a liquid, comprising (i) at least one treatment surface with at least one inflow region (2) having a multitude of pass-through openings (6) out of which the flat object (1) can be streamed against by a first liquid (L1), and (ii) at least one discharge region (3) for discharging said first liquid (L1) after provision of the inflow, **characterized in that** the treatment surface is further equipped with at least one pocket (4) for the provision of a velocity controlling liquid roller, wherein said pocket (4) has at its upstream edge an inlet (5A) through which a second liquid (L2) can be fed into said pocket (4) in the form of a liquid jet stream (8).

2. Apparatus according to claim 1, wherein the at least one discharge region (3) is laterally adjoining the treatment surface's at least one inflow region (2) at least at one of its sides.

3. Apparatus according to claim 1 or 2, wherein the pocket (4) comprises at least one outlet (5B).

4. Apparatus according to any of claims 1 to 3, comprising a means (9A, 9B) for adjusting the mass flow and/or the impulse of the second liquid (L2) entering and/or the mass flow of the second liquid (L2) leaving the pocket (4).

5. Apparatus according to any of claims 3 or 4, wherein a grating (10) is arranged at the opening of the outlet (5B).

6. Apparatus according to any of claims 1 to 5, wherein several pockets (4) are arranged perpendicular to the transport direction (T) side by side.

7. Apparatus according to any of claims 1 to 6, wherein, along the length of one object (1), an identical number of pockets (4) and inflow regions (2) are subsequently and alternately arranged in transport direction (T) one after another, and/or wherein the cumulated length of pockets (4) along a section of the treatment surface ranges between 0.5 and 5 times the cumulated length of the inflow regions (2) of this section.

8. Apparatus according to any of claims 1 to 7, wherein the inflow regions (2) are arranged on the treatment surface in a V-shape.

9. Apparatus according to any of claims 1 to 8, wherein the respective inlets (5A) and/or optionally present outlets (5B) of a multitude of pockets (4) are fluidically combined.

10. Method for the velocity controlled horizontal transport of a substantially flat and freely moveable object (1) on a liquid, wherein (i) the flat object (1) is streamed against by a first liquid (L1) emitted from a multitude of pass-through openings (6) which are comprised by at least one inflow region (2) of at least one treatment surface, and (ii) said first liquid (L1) is discharged after provision of the inflow into at least one discharge region (3), **characterized in that** a velocity controlling fluid roller with a flow component in transport direction (T) is provided in the form of a jet stream (8) of second liquid (L2) which is fed through an inlet (5A) being arranged at a pocket's upstream edge into said pocket (4), the pocket (4) being also present in the treatment surface.

11. Method according to claim 10, wherein the second liquid (L2) is discharged via the treatment surface and/or via an open bottom which is arranged within the pocket (4).

12. Method according to claim 10, wherein the second liquid (L2) is discharged into at least one outlet (5B) which is arranged within the pocket (4).

13. Method according to any of claims 10 to 12, wherein the inflowing mass flow (Mᵢₙ) of the second liquid (L2) entering the pocket (4) is equal to or greater than the outflowing mass flow (Mₒᵤₜ) leaving the pocket (4).

14. Method according to any of claims 10 to 13, wherein adjustment of the surface speed (v) takes place by adjusting the second liquids (L2) mass flow and/or impulse entering the pocket (4), and/or the second liquids (L2) mass flow leaving the pocket (4).

15. Method according to any of claims 10 to 14, wherein the surface speeds (v) of the jets (8) of a multitude of pockets (4) are commonly adjusted.

16. Method according to any of claims 10 to 15, wherein the motion impulse of the second liquid (L2) entering the pocket (4) is adjusted to be large with respect to the motion impulse transferred to the object (1).

17. Method according to any of claims 10 to 16, wherein a settling region (11) of little or no flow develops below the liquid jet (8).

## Patentansprüche

1. Vorrichtung zum geschwindigkeitskontrollierten horizontalen Transport eines im Wesentlichen flachen und frei beweglichen Gegenstands (1) auf einer Flüssigkeit, umfassend (i) mindestens eine Behandlungsfläche mit mindestens einem Anströmbereich (2) mit einer Vielzahl von Durchtrittsöffnungen (6), aus welchen der flache Gegenstand (1) durch eine erste Flüssigkeit (L1) anströmbar ist, und (ii) mindestens einen Ablaufbereich (3) zum Abführen der ersten Flüssigkeit (L1) nach dem Anströmen, **dadurch gekennzeichnet, dass** die Behandlungsfläche ferner mit mindestens einer Tasche (4) zur Bereitstellung einer die Geschwindigkeit kontrollierenden Flüssigkeitswalze, wobei die Tasche (4) an ihrem stromaufwärts gelegenen Ende einen Einlass (5A) aufweist, durch welchen eine zweite Flüssigkeit (L2) in Form eines Flüssigkeitsstrahlstroms (8) in die Tasche (4) eingeleitet werden kann.

2. Vorrichtung nach Anspruch 1, wobei der mindestens eine Ablaufbereich (3) seitlich an den mindestens einen Anströmbereich (2) der Behandlungsfläche an mindestens einer seiner Seiten angrenzt.

3. Vorrichtung nach Anspruch 1 oder 2, wobei die Tasche (4) mindestens einen Auslass (5B) aufweist.

4. Vorrichtung nach einem der Ansprüche 1 bis 3, umfassend Mittel (9A, 9B) zum Einstellen des Massenstroms und/oder des Impulses der in die Tasche (4) einströmenden zweiten Flüssigkeit (L2), und/oder des Massenstroms der aus der Tasche (4) ausströmenden zweiten Flüssigkeit (L2).

5. Vorrichtung nach einem der Ansprüche 3 oder 4, wobei an der Öffnung des Auslasses (5B) ein Gitter (10) angeordnet ist.

6. Vorrichtung nach einem der Ansprüche 1 bis 5, wobei mehrere Taschen (4) nebeneinander senkrecht zur Transportrichtung (T) angeordnet sind.

7. Vorrichtung nach einem der Ansprüche 1 bis 6, wobei entlang der Länge eines Gegenstandes (1) in Transportrichtung (T) eine identische Anzahl von Taschen (4) und Anströmbereichen (2) nacheinander und alternierend angeordnet ist, und/oder wobei die kumulierte Länge von Taschen (4) entlang eines Abschnittes der Behandlungsfläche das 0,5- bis 5-fache der kumulierten Länge der Anströmbereiche (2) dieses Abschnittes beträgt.

8. Vorrichtung nach einem der Ansprüche 1 bis 7, wobei die Anströmbereiche (2) auf der Behandlungsfläche V-förmig angeordnet sind.

9. Vorrichtung nach einem der Ansprüche 1 bis 8, wobei die jeweiligen Einlässe (5A) und/oder optional vorhandenden Auslässe (5B) einer Vielzahl von Taschen (4) fluidisch kombiniert sind.

10. Verfahren zum geschwindigkeitskontrollierten horizontalen Transport eines im Wesentlichen flachen und frei beweglichen Gegenstands (1) auf einer Flüssigkeit, wobei (i) der flache Gegenstand (1) von einer ersten, aus einer Vielzahl von Durchtrittsöffnungen (6), die von mindestens einem Anströmbereich (2) mindestens einer Behandlungsfläche umfasst sind, emittierten Flüssigkeit (L1) angeströmt wird, und (ii) diese erste Flüssigkeit (L1) nach dem Anströmen in mindestens einen Ablaufbereich (3) abgeführt wird, **dadurch gekennzeichnet, dass** eine die Geschwindigkeit kontrollierende Flüssigkeitswalze mit einer Strömungskomponente in Transportrichtung (T) bereitgestellt wird in Form eines Strahlstroms (8) einer zweiten Flüssigkeit (L2), welche durch einen an einem stromaufwärts gelegenen Ende einer Tasche (4) angeordneten Einlass (5A) in diese Tasche (4) eingeleitet wird, wobei diese Tasche (4) ebenfalls in der Behandlungsfläche vorhanden ist.

11. Verfahren nach Anspruch 10, wobei die zweite Flüssigkeit (L2) über die Behandlungsfläche und/oder über einen offenen Boden innerhalb der Tasche (4) abgeführt wird.

12. Verfahren nach Anspruch 10, wobei die zweite Flüssigkeit (L2) über mindestens einen innerhalb der Tasche (4) angeordneten Auslass (5B) abgeführt wird.

13. Verfahren nach einem der Ansprüche 10 bis 12, wobei der in die Tasche (4) einströmende Massenstrom (Mₑᵢₙ) der zweiten Flüssigkeit (L2) gleich oder größer als der aus der Tasche (4) strömende Massenstrom (Mₐᵤₛ) ist.

14. Verfahren nach einem der Ansprüche 10 bis 13, wobei das Einstellen der Flächengeschwindigkeit (V) durch Einstellen des Massenstroms und/oder des Impulses der in die Tasche (4) einströmenden zweiten Flüssigkeit (L2), und/oder des Massenstroms der aus der Tasche (4) ausströmenden zweiten Flüssigkeit (L2) erfolgt.

15. Verfahren nach einem der Ansprüche 10 bis 14, wobei die Flächengeschwindigkeiten (V) der Strahlen (8) einer Vielzahl von Taschen (4) gemeinsam eingestellt werden.

16. Verfahren nach einem der Ansprüche 10 bis 15, wobei der Bewegungsimpuls der in die Tasche (4) einströmenden zweiten Flüssigkeit (L2) im Hinblick auf den auf den Gegenstand (1) übertragenden Bewegungsimpuls groß eingestellt wird.

17. Verfahren nach einem der Ansprüche 10 bis 16, wobei sich unterhalb des Flüssigkeitsstrahls (8) ein Absetzbereich (11) mit geringer oder keiner Strömung ausbildet.

## Revendications

1. Appareil pour le transport horizontal à vitesse contrôlée d'un objet (1) substantiellement plat et mobile librement sur un liquide, comprenant (i) au moins une surface de traitement avec au moins une région de flux entrant (2) ayant une multitude d'ouvertures (6) permettant le passage de liquide, de laquelle l'objet plat (1) peut s'éloigner par l'écoulement d'un premier liquide (L1) contre l'objet plat, et (ii) au moins une région de décharge (3) pour l'évacuation du dit premier liquide (L1) après avoir fourni le flux entrant, **caractérisé en ce que** la surface de traitement est de plus équipée d'au moins une poche (4) qui permet de former un rouleau liquide contrôlant la vitesse, dans lequel la dite poche (4) a une arrivée de liquide (5A) du coté amont à travers laquelle un second liquide (L2) peut être injecté dans la dite poche (4) sous la forme d'un jet de liquide (8).

2. Appareil selon la revendication 1 dans lequel la, au moins une, région de décharge (3) est accolée latéralement à la, au moins une, région de flux entrant (2) de la surface de traitement par au moins un de ses cotés.

3. Appareil selon la revendication 1 ou 2 dans lequel la poche (4) comprend au moins une sortie (5B).

4. Appareil selon une des revendications 1 à 3 comprenant un dispositif (9A, 9B) pour ajuster le débit massique et/ou l'impulsion du second liquide (L2) entrant et/ou le débit massique du second liquide (L2) sortant de la poche (4).

5. Appareil selon une des revendications 3 ou 4 dans lequel une grille (10) est placée à l'ouverture de la sortie (5B).

6. Appareil selon une des revendications 1 à 5 dans lequel plusieurs poches (4) sont placées perpendiculairement à la direction de transport (T) côte à côte.

7. Appareil selon une des revendications 1 à 6 dans lequel, dans le sens de la longueur d'un objet (1), un nombre identique de poches (4) et de régions de flux entrant (2) sont placées subséquemment et alternativement dans la direction du transport (T), une après l'autre, et/ou dans lequel la longueur cumulée des poches (4) le long d'une section de surface de traitement est comprise entre 0,5 et 5 fois la longueur cumulée des régions de flux entrant (2) de cette section.

8. Appareil selon une des revendications 1 à 7 dans lequel les régions de flux entrant (2) sont placées sur la surface de traitement en forme de V.

9. Appareil selon une des revendications 1 à 8 dans lequel les arrivées de liquide respectives (5A) et/ou en option les sorties présentés (5B) d'une multitude de poches (4) sont couplées par l'intermédiaire d'un fluide.

10. Méthode pour le transport horizontal à vitesse contrôlée d'un objet (1) substantiellement plat et mobile librement sur un liquide, dans laquelle (i) l'objet plat (1) peut s'éloigner par l'écoulement d'un premier liquide (L1) émis par une multitude d'ouvertures (6) permettant le passage du liquide qui sont inclues dans au moins une région de flux entrant (2) d'au moins une surface de traitement, et (ii) le dit premier liquide (L1) est évacué après avoir fourni le flux entrant par au moins une région de décharge (3), **caractérisée en ce que** un rouleau de liquide contrôlant la vitesse avec une composante de flux dans la direction du transport (T) est formé par un jet de liquide (8) d'un second liquide (L2) qui est injecté à travers une arrivée de liquide (5A) placée du coté amont d'une poche dans la dite poche (4), la poche (4) étant également présente dans la surface de traitement.

11. Méthode selon la revendication 10 dans laquelle le second liquide (L2) est évacué via la surface de traitement et/ou via un fond ouvert qui est placé dans la poche (4).

12. Méthode selon la revendication 10 dans laquelle le second liquide (L2) est évacué par au moins une sortie (5B) qui est placée dans la poche (4).

13. Méthode selon une des revendications 10 à 12 dans laquelle le débit massique d'entrée (Mₑₙₜ) du second liquide (L2) entrant dans la poche (4) est égal à ou plus grand que le débit massique de sortie (Mₛₒᵣ) quittant la poche (4).

14. Méthode selon une des revendications 10 à 13 dans laquelle l'ajustement de la vitesse à la surface (v) est effectuée en ajustant le débit massique du second liquide (L2) et/ou l'impulsion d'entrée dans la poche (4), et/ou le débit massique du second liquide (L2) quittant la poche (4).

15. Méthode selon une des revendications 10 à 14 dans laquelle les vitesses de surface (v) des jets (8) d'une multitude de poches (4) sont ajustées de concert.

16. Méthode selon une des revendications 10 à 15 dans laquelle l'impulsion motrice du second liquide (L2) entrant dans la poche (4) est ajustée pour être suffisamment forte par rapport à l'impulsion motrice transférée à l'objet (1).

17. Méthode selon une des revendications 10 à 16 dans laquelle une région de décantation (11) avec peu ou pas de flux se développe sous le jet de liquide (8).
